# DEMANDE DE BREVET EUROPEEN

(11) **EP 4 391 031 A1**
(43) Date de publication de la demande: **26.06.2024**
(21) Numéro de dépôt: 23214808.0
(22) Date de dépôt: 07.12.2023
(51) Int. Cl.: H01L 21/677

(54) **SYSTÈME DE TRANSPORT D'UN SUBSTRAT SEMI-CONDUCTEUR**

(30) Priorité: 19.12.2022 FR 2213736
(71) Demandeur: Commissariat à l'énergie atomique et aux énergies alternatives, 75015 Paris (FR)
(72) Inventeur: JERONIMO, Pedro, 38054 GRENOBLE CEDEX 09 (FR); BARBERO, William, 38054 GRENOBLE CEDEX 09 (FR); HOTEL, Julien, 38054 GRENOBLE CEDEX 09 (FR)
(74) Mandataire: Brevalex

(57) **Abrégé**

L'invention concerne un système de transport d'un substrat semi-conducteur (110), lors de la réalisation d'au moins un dispositif semi-conducteur comprenant ce substrat (110), ledit système comprenant au moins un élément de manutention et/ou de maintien (102) du substrat semi-conducteur (110), ledit au moins un élément de manutention et/ou de maintien (102) comprenant, sur au moins une zone d'une face (102e) dudit au moins un élément de manutention et/ou de maintien (102) destinée à être en regard d'une région de contact (Rc) du substrat (110), au moins un élément de support (108) en saillie par rapport à la face (102e) dudit au moins un élément de manutention et/ou de maintien (102), et destiné à venir au contact de la région de contact (Rc) du substrat (110) de sorte à maintenir à distance le substrat (110) et la face (102e) dudit au moins un élément de manutention et/ou de maintien (102).

## Description

### Domaine technique et art antérieur

L'invention est relative au domaine du transport, ou de l'acheminement, et du maintien de substrats, ou plaquettes, de semi-conducteur lors de la réalisation de dispositifs à partir de ces substrats. L'invention s'applique avantageusement à des substrats semi-conducteurs destinés à la réalisation de cellules photovoltaïques, mais également à des substrats semi-conducteurs destinés à la réalisation de dispositifs microélectroniques.

Au cours de la réalisation de dispositifs semi-conducteurs (par exemple photovoltaïques, microélectroniques, etc.), les substrats semi-conducteurs, par exemple en silicium, à partir desquels ces dispositifs sont réalisés passent successivement dans différents équipements au sein desquels les substrats sont soumis à différents traitements permettant de réaliser les dispositifs semi-conducteurs : dépôt de matériaux, gravure, photolithographie, etc. Un système de transport, comportant différents éléments de manutention, manuels ou automatiques, et/ou de maintien des substrats, permet d'acheminer et de maintenir les substrats au sein de ces équipements. Ces éléments de manipulation et/ou de maintien correspondent à des courroies, des préhenseurs à vide, des plateaux, des paniers, etc.

Lors de son transport, le substrat entre en contact avec les éléments de manipulation et/ou de maintien. Or, les zones du substrat semi-conducteur entrant en contact avec les éléments de manipulation et/ou de maintien sont détériorées par ces contacts : abrasion de la surface du substrat, dépôt, voire même incrustation, de contaminants (particules, dépôts divers) sur cette surface, etc. Les défauts résultant de ces dégradations de surface sont englobés sous le terme « défectivité ». Les éléments réalisés ensuite sur ces zones où la surface du substrat est dégradée sont de moindre qualité. Par exemple, une couche de passivation d'épaisseur nanométrique (par exemple égale à environ 10 nm) déposée par dépôt chimique en phase vapeur assisté par plasma (PECVD pour « Plasma-Enhanced Chemical Vapor Déposition » en anglais) sur une surface du substrat comprenant des zones avec de tels défauts est de moindre qualité (présence de contaminants, mauvaise adhérence, dépôt localement absent, etc.). Il en résulte sur le substrat des zones passivées de façon médiocre par rapport à une surface de substrat sans défectivité. Dans le cas particulier des cellules photovoltaïques à hétérojonction de silicium réalisées par dépôt PECVD de couches de a-Si:H (silicium amorphe hydrogéné) sur des substrats de silicium monocristallin, cette défectivité engendre une chute du facteur de forme (FF), comme cela est par exemple décrit dans le document de O. Nos et al., Sol. En. Mat. & Sol. Cells 144 (2016) pp. 210-220, voire de la tension de circuit ouvert (Voc), et donc du rendement de conversion, des cellules.

Pour réduire la défectivité causée par le système de transport utilisé lors de la réalisation d'un dispositif semi-conducteur, la demande de brevet français FR 3 073 081 propose un substrat semi-conducteur comprenant, sur des zones d'au moins une de deux faces principales du substrat destinées à être en regard de régions de contact d'éléments de manipulation et/ou de maintien, des éléments de support en saillie par rapport à ladite au moins une des deux faces principales du substrat tels que seuls les éléments de support soient en contact avec les régions de contact lors de la manipulation et/ou du maintien du substrat par les éléments de manipulation et/ou de maintien.

Néanmoins, la fabrication et l'utilisation d'un tel substrat sont complexes. D'une part, de la matière est ajoutée sur chaque substrat pour former ces éléments de support ce qui, d'un point de vue économique et/ou écologique, n'est pas entièrement satisfaisant. Le positionnement de ces éléments de support implique de plus d'identifier, sur le substrat, des zones où les éléments de manipulation et/ou de maintien sont destinés à être en contact avec le substrat. D'autre part, un tel substrat requiert un positionnement précis sur les éléments de manipulation et/ou de maintien pour que les éléments de support du substrat soient en contact avec les régions de contact. Si le substrat est mal positionné, il existe un risque qu'une zone d'au moins une des deux faces principales du substrat qui est dépourvue d'éléments de support soit au contact des éléments de manipulation et/ou de maintien et s'en trouve ainsi détériorée. Ce risque est d'autant plus élevé lorsque le substrat est, lors de son transport, positionné sur des éléments de manipulation et/ou de maintien de configurations différentes. En effet, à moins de former des éléments de support sur l'intégralité d'au moins une des deux faces principales du substrat, l'adaptabilité d'un tel substrat à des éléments de manipulation et/ou de maintien de configurations différentes est limitée.

On connaît également des documents WO 2013/110582, DE 102011110616, JPS 6413340 et US 2011/068092, des dispositifs à courroie comprenant des éléments de support faisant saillie de la courroie et sur lesquels sont disposés des substrats.

### Exposé de l'invention

Un but de la présente invention est de proposer une solution résolvant tout ou partie des inconvénients évoqués ci-dessus.

Pour cela, l'invention propose un système de transport d'un substrat semi-conducteur, lors de la réalisation d'au moins un dispositif semi-conducteur sur ce substrat, ledit système comprenant au moins un élément de manutention et/ou de maintien du substrat semi-conducteur, ledit au moins un élément de manutention et/ou de maintien comprenant, sur au moins une zone d'une face dudit au moins un élément de manutention et/ou de maintien destinée à être en regard d'une région de contact du substrat, au moins un élément de support en saillie par rapport à la face dudit au moins un élément de manutention et/ou de maintien, et destiné à venir au contact de la région de contact du substrat de sorte à maintenir à distance le substrat et la face dudit au moins un élément de manutention et/ou de maintien. L'au moins un élément de support comprenant un trou, notamment formé sur toute la hauteur de l'au moins un élément de support, débouchant sur une surface de l'au moins un élément de support destinée à venir au contact du substrat.

Grâce à l'au moins un élément de support formé sur une face dudit au moins un élément de manutention et/ou de maintien, l'au moins une zone où le substrat est en contact avec le système de transport est contrôlée et limitée à l'au moins une zone correspondant à l'au moins un élément de support. La présence de cet au moins un élément de support limite les dégradations induites par ce contact car le substrat est maintenu à distance de la face dudit au moins un élément de manutention et/ou de maintien, dont la surface est plus grande que la surface de l'au moins un élément de support destinée à venir au contact du substrat. La surface des zones de défectivité du substrat créées lors du transport du substrat sont donc contrôlées et fortement réduites par rapport à un élément de manutention et/ou de maintien dépourvu d'élément de support.

En formant l'au moins un élément de support sur l'au moins un élément de manutention et/ou de maintien, les substrats sont plus faciles à fabriquer, tout en étant adaptables à des éléments de manutention et/ou de maintien de configurations différentes. En particulier, il est plus facile de fabriquer seulement un élément de manutention et/ou de maintien qui est pourvu d'au moins un élément de support au lieu de former sur chaque substrat des éléments de support adaptés à une configuration spécifique d'un élément de manutention et/ou de maintien.

En outre, la présence d'un trou débouchant sur une surface destinée à venir au contact du substrat permet, lorsque le substrat obture le trou, de créer une aspiration qui améliore le maintien du substrat sur l'élément de manutention et/ou de maintien. Cette configuration permet au surplus de réduire la surface de contact entre l'élément de support et le substrat.

L'invention s'applique avantageusement pour des substrats destinés à la réalisation de dispositifs dans lesquels l'état de surface du substrat, c'est-à-dire la qualité du semi-conducteur, joue un rôle majeur sur la performance finale du dispositif. De plus, l'invention s'applique avantageusement pour des dispositifs dont la réalisation nécessite un transport rapide des substrats, avec une forte cadence, lors des étapes précédant la protection de la surface du substrat, c'est-à-dire les étapes précédant la passivation de surface du substrat à partir de laquelle le système de transport n'a plus ou presque plus d'impact sur la qualité du semi-conducteur du substrat.

Enfin, l'invention s'applique particulièrement pour des substrats de silicium destinés à la réalisation de cellules photovoltaïques et incluant, lors de la réalisation des cellules photovoltaïques, au minimum une étape de passivation de surface. Ainsi, les substrats de silicium servant à la réalisation de cellules photovoltaïques à hétérojonctions sont particulièrement concernés par cette invention.

L'invention s'applique avantageusement pour des substrats fins, c'est-à-dire dont l'épaisseur est inférieure ou égale à environ 120 µm, car ces substrats sont plus sensibles à la défectivité que des substrats épais de plusieurs centaines de microns.

Des caractéristiques préférées particulièrement simples, commodes et économiques du dispositif selon l'invention sont présentées ci-dessous.

L'au moins un élément de manutention et/ou de maintien peut être solidaire d'un arbre rotatif et entraîné en rotation par ledit arbre rotatif.

Le système de transport peut comporter au moins deux éléments de manutention et/ou de maintien espacés l'un de l'autre. Chaque élément de manutention et/ou de maintien peut comprendre, sur ladite au moins une zone de la face dudit élément de manutention et/ou de maintien destinée à être en regard d'une région de contact du substrat, au moins un élément de support.

L'au moins un élément de manutention et/ou de maintien peut comprendre au moins une courroie.

L'au moins un élément de support peut avoir une hauteur minimale prédéfinie en fonction de dimensions, notamment l'épaisseur et le format, du substrat, la hauteur étant de préférence supérieure à 200 µm. De préférence la hauteur peut être comprise entre 300 µm et 1 mm.

L'au moins un élément de support peut avoir une surface destinée à venir au contact du substrat inférieure à 10 mm², de préférence comprise entre 0.5 mm² et 5 mm².

L'au moins un élément de support peut avoir une forme conique, notamment tétraédrique, ou pyramidale, notamment une forme tronquée.

, ledit trou étant destiné à être obturé par ledit substrat lorsque ledit au moins un élément de support est au contact de ladite région de contact du substrat.

L'au moins un élément de support peut avoir une épaisseur, entre une surface interne dudit au moins un élément de support définissant le trou et une surface externe dudit au moins un élément de support, qui est amincie du côté de la surface destinée à venir au contact du substrat.

L'au moins un élément de manutention et/ou de maintien peut comprendre une pluralité d'éléments de support alignés selon une direction de déplacement de l'élément de manutention et/ou de maintien et espacés régulièrement les uns des autres d'une distance prédéfinie en fonction de dimensions, notamment l'épaisseur et le format, du substrat, cette distance étant de préférence comprise entre 78 mm et 108,5 mm.

L'au moins un élément de support peut être rapporté sur la face dudit au moins un élément de manutention et/ou de maintien, notamment par collage ou par soudage.

L'invention a aussi pour objet, selon un deuxième aspect, un ensemble de transport d'un substrat semi-conducteur, comprenant un système de transport tel que décrit ci-dessus et un substrat semi-conducteur, dans lequel ledit au moins un élément de support est au contact de la région de contact dudit substrat de sorte à maintenir à distance le substrat et la face dudit au moins un élément de manutention et/ou de maintien, et dans lequel ledit trou dudit au moins un élément de support est obturé par ledit substrat.

L'au moins un élément de support peut être au contact d'au moins un bord du substrat.

Selon un exemple, le substrat peut être au contact de deux éléments de support, à savoir un premier élément de support au contact d'un premier bord du substrat et un deuxième élément de support au contact d'un deuxième bord du substrat opposé au premier bord.

Selon un autre exemple, le substrat est au contact de trois éléments de support agencés en forme de triangle.

Selon encore un autre exemple, le substrat peut avoir une forme rectangulaire, pseudo-rectangulaire, carrée ou pseudo-carrée et peut être au contact de quatre éléments de support, ces éléments de support étant agencés sensiblement à chaque coin du substrat. Par pseudo-rectangulaire ou pseudo-carré, il est entendu une forme globalement rectangulaire ou carré, avec par exemple des angles arrondis ou des bords qui ne sont pas parfaitement rectilignes.

L'espacement, suivant une direction d'avancement de l'au moins un élément de manutention et/ou de maintien, entre deux éléments de support consécutifs peut être sensiblement inférieur à la moitié de la dimension d'un côté du substrat le long duquel ces éléments de support sont en contact.

L"invention a enfin pour objet, selon un troisième aspect, un procédé de transport d'un substrat semi-conducteur avec un ensemble de manutention et/ou de maintien tel que décrit ci-dessus, le procédé comprenant une étape de positionnement du substrat au contact dudit au moins un élément de support de sorte à maintenir à distance ledit substrat et la face dudit au moins un élément de manutention et/ou de maintien et à obturer ledit trou dudit au moins un élément de support avec ledit substrat.

### Brève description des dessins

La présente invention sera mieux comprise à la lecture de la description d'exemples de réalisation donnés à titre purement indicatif et nullement limitatif en faisant référence aux dessins annexés sur lesquels :
- la figure 1 représente schématiquement un système de transport d'un substrat semi-conducteur, objet de la présente invention, selon un premier mode de réalisation ;
- la figure 2 représente un ensemble formé du système de transport selon le premier mode de réalisation et de substrats semi-conducteurs disposés sur des éléments de manutention et/ou de maintien du système de transport, et montre un premier exemple de répartition d'éléments de support des éléments de manutention et/ou de maintien;
- la figure 3 est une vue similaire à celle de la figure 2 et montre un deuxième exemple de répartition des éléments de support des éléments de manutention et/ou de maintien;
- la figure 4 est une vue similaire à celles des figures 2 et 3 et montre un troisième exemple de répartition des éléments de support des éléments de manutention et/ou de maintien;
- la figure 5 est une vue de profil de l'ensemble illustré aux figures 3 et 4;
- la figure 6 est une vue de détail montrant un élément de support au contact d'un substrat semi-conducteur ;
- la figure 7 représente schématiquement, selon une vue en perspective, un élément de support pris de manière isolée ; et
- la figure 8 est une vue en coupe suivant le plan A illustré à la figure 7.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### Exposé détaillé de modes de réalisation particuliers

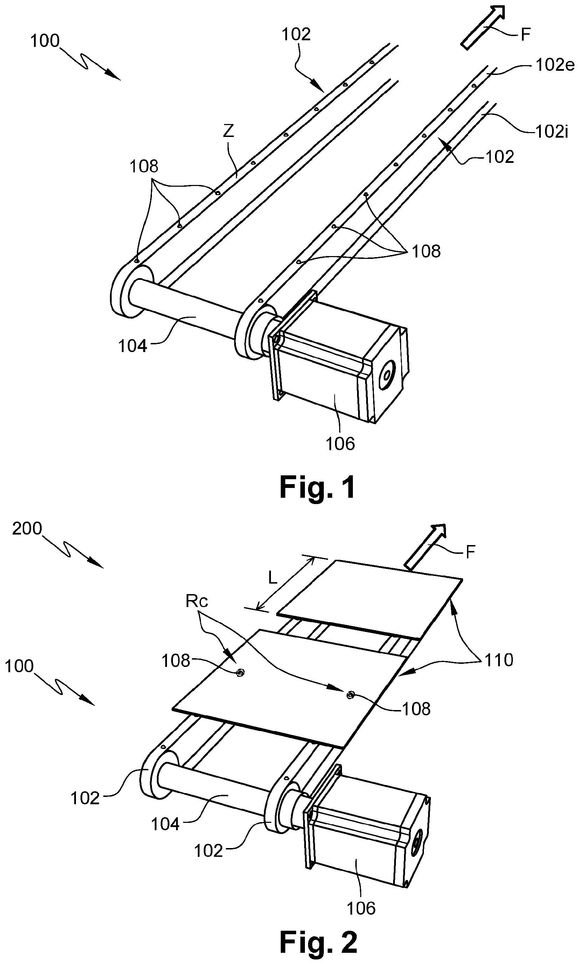

On se réfère tout d'abord à la figure 1 qui représente un système de transport 100 selon un premier mode de réalisation.

Le système 100 est destiné à transporter un substrat semi-conducteur, lors de la réalisation d'au moins un dispositif semi-conducteur sur ce substrat. Dans ce premier mode de réalisation, le système 100 comprend une paire d'éléments de manutention et/ou de maintien 102 du substrat semi-conducteur destinés à supporter un substrat semi-conducteur. Les éléments 102 sont espacés l'un de l'autre suivant une direction transversale à une direction d'avancement, portant la référence F, de ces éléments 102. Les éléments 102 correspondent à des courroies plates. En variante, le système peut comprendre un élément de manutention et/ou de maintien central.

Les éléments de manutention et/ou de maintien 102 sont entraînés en rotation par un arbre rotatif 104, lui-même entraîné en rotation par un moteur électrique 106. L'arbre rotatif 104 et le moteur électrique 106 sont disposés transversalement à la direction d'avancement F des éléments 102.

Les éléments de manutention et/ou de maintien 102 comportent chacun une face 102e dite externe et une face 102i dite interne opposée à la face 102e externe. La face 102e externe est destinée à être en regard du substrat semi-conducteur et comporte, sur une zone Z de cette face 102e, des éléments de support 108 en saillie par rapport à la face 102e externe. La zone Z est par exemple par exemple, une zone centrale ou médiane de chaque élément 102, espacée des bords longitudinaux.

Les éléments de support 108 sont alignés, sur la face 102e externe, suivant la direction de déplacement F des éléments 102. Sur l'exemple de réalisation représenté sur la figure 1, les éléments de support 108 sont régulièrement répartis sur la face 102e externe de chaque élément 102. Les éléments de support 108 sont répartis sur chaque élément 102 de sorte que les éléments de support 108 disposés sur un des éléments 102 sont au même niveau d'avancement, c'est-à-dire alignés selon une direction transversale à la direction d'avancement F, que les éléments de support 108 disposés sur l'autre des éléments 102.

Les éléments de support 108 peuvent être formés d'un seul tenant avec l'élément 102 ou rapportés, par exemple par collage, soudage ou tout autre procédé d'assemblage, sur la face 102e externe de l'élément 102.

Les figures 2 à 4 représentent un ensemble 200 formé par le système 100 et deux substrats 110 disposés sur les éléments de manutention et/ou de maintien 102. Les substrats 110 sont alignés et espacés suivant la direction d'avancement F des éléments 102.

Chaque substrat 110 est au contact des éléments de manutention et/ou de maintien 102 par l'intermédiaire des éléments de support 108. Les autres zones ou régions de la face externe des éléments 102 se trouvant autour des éléments de support 108 ne sont pas en contact avec les substrats 110. Les zones ou portions de chaque substrat 110 au contact des éléments de support 108 sont appelées régions de contact et portent la référence Rc. Ces régions de contact Rc sont impactées par le contact avec les éléments de support 108 et subissent la création de défauts. Ainsi, les autres régions ou zones du substrat 110 qui ne sont pas au contact des éléments de support 108 restent intactes lors de la manutention et/ou le maintien du substrat 110 par les éléments 102.

Si le substrat 110 inclus des portions ou régions de moindre importance pour sa performance, alors les éléments de support 108 sont de préférence agencés de sorte à venir au contact de ces portions ou régions. Par exemple, dans le cas des cellules photovoltaïques contenant des busbars (ou barres d'interconnexion), il est particulièrement intéressant de disposer les éléments de support 108 de telle manière qu'ils viennent en contact avec ces busbars. Avantageusement, les régions de contact Rc sont situées près des bords du substrat 110. Le nombre d'éléments de support 108 au contact d'un substrat 110 peut néanmoins varier, de même que l'agencement de ces éléments 108 sur les éléments 102.

La figure 2 montre un premier exemple de réalisation des éléments 102 dans lequel la répartition des éléments de support 108 permet de limiter, voire prévenir le contact du substrat 110 avec la face 102e externe de chaque élément 102. Sur cette figure, le substrat 110 est au contact de deux éléments de support 108 répartis sur les éléments 102. Les éléments de support 108 sont au contact de bords opposés du substrat 110, et préférentiellement au centre de chacun de ces bords pour améliorer l'équilibre du substrat 110 et donc son maintien sur les éléments 102. Dans cette configuration, il existe un risque de basculement du substrat 110 au moment de phases de démarrage (accélération) et/ou d'arrêt (décélération) du système 100.

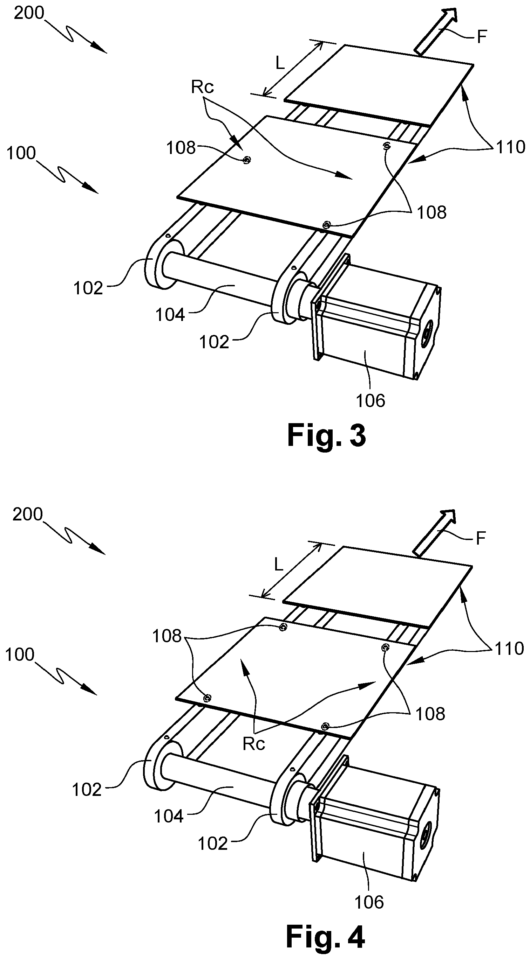

La figure 3 montre un deuxième exemple de réalisation des éléments 102, dans lequel le substrat 110 est au contact de trois éléments de support 108 répartis de la manière suivante : deux éléments de support 108 sont disposés sur un des éléments 102 et un élément de support 108 est disposé sur l'autre des éléments 102. Les deux éléments de support 108 disposés sur le même élément 102 sont au contact d'un bord de substrat 110, chacun de ces éléments de support 108 étant à une extrémité longitudinale de ce bord. L'élément de support 108 disposé sur l'autre élément 102 est au contact d'un bord opposé du substrat 110, préférentiellement au centre de ce bord. Ces éléments de support 108 sont alors agencés en triangle. Par rapport à la configuration représentée à la figure 2, le risque de basculement du substrat 110 au moment des phases de démarrage et/ou d'arrêt du système 100 est réduit.

La figure 4 montre un troisième exemple de réalisation des éléments 102, dans lequel le substrat 110 est au contact de quatre éléments de support 108 répartis uniformément sur les éléments 102. Les éléments de support 108 disposés sur un des éléments 102 sont au contact d'un premier bord du substrat 110 tandis que les éléments de support 108 de l'autre des éléments 102 sont au contact d'un deuxième bord opposé au premier bord du substrat 110. Les éléments de support 108 sont de préférence disposés de sorte à être au contact de chaque coin du substrat 110. Par rapport à la configuration représentée à la figure 3, le risque de basculement du substrat 110 au moment de phases de démarrage ou d'arrêt du système 100 est encore réduit.

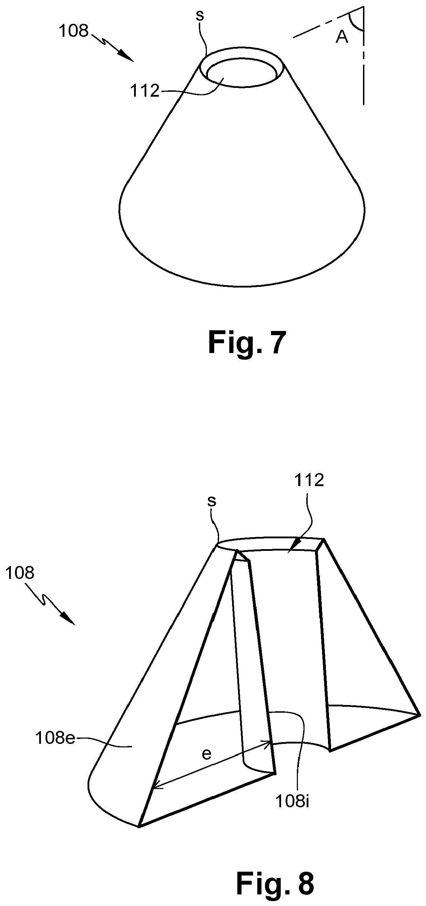

Le nombre d'éléments de support 108, leur disposition et leur surface s (figure 7) d'occupation sur le substrat 110 sont choisis judicieusement afin de réduire au maximum l'impact des contacts avec les éléments 102. Par exemple, la surface s des éléments de support 108 au contact du substrat 110 peut être augmentée pour réduire le risque de basculement du substrat 110, notamment pour les configurations illustrées aux figures 2 et 3.

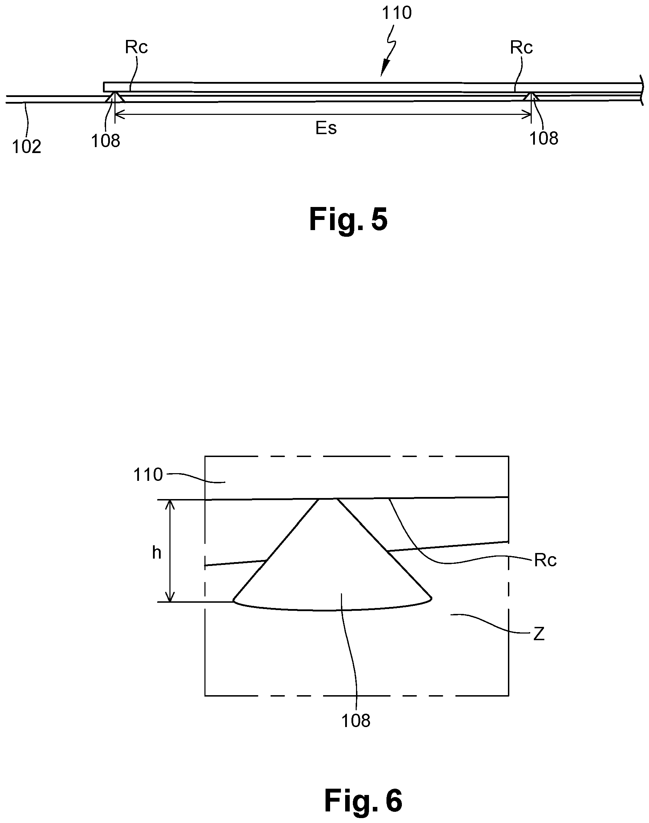

La figure 5 représente, selon une vue de côté, l'ensemble 200 de la figure 4 ou celui de la figure 3 du côté où le substrat 110 est au contact de deux éléments de support 108. La répartition de ces éléments de support 108 sur la face 102e externe de chaque élément 102 est dictée par les dimensions du substrat 110 à transporter. Cette répartition est choisie judicieusement telle que les éléments de support 108 entrent en contact avec le substrat 110 sur une surface qui est la plus petite possible, c'est-à-dire en formant de préférence le moins d'éléments de support 108 possible tout en assurant l'absence de contact parasite entre le reste du substrat 110 et la face 102e externe des éléments 102.

L'espacement Es maximum entre deux éléments de support 108 consécutifs destinés à venir au contact d'un même substrat 110 est sensiblement égal à la dimension L du bord ou du côté du substrat 110 avec lequel ces éléments 108 entrent en contact. Avec un tel espacement, les éléments de support 108 sont au contact des extrémités longitudinales d'un bord du substrat 110. Il existe un risque pour que, lorsque le substrat 110 est mal positionné ou glisse, le substrat 110 ne soit plus au contact de chaque élément de support 108 et contacte la face 102e externe d'un ou de chacun des éléments 102.

De préférence, l'espacement Es entre deux éléments de support 108 consécutifs est sensiblement égal, voire inférieur à la moitié de la dimension L du bord au contact des éléments de support 108. De cette manière, le substrat 110 est toujours au contact d'au moins deux éléments de support 108, même lorsque le substrat 110 est mal positionné ou glisse. Le risque pour que le substrat 110 ne soit plus au contact de chaque élément de support 108 est donc évité.

En référence à la figure 6, les éléments de support 108 sont réalisés tels que leur hauteur h soit suffisante pour éloigner suffisamment le reste de la surface du substrat 110 vis-à-vis de la face 102e externe des éléments 102. Ainsi, la hauteur h des éléments de support 108 peut être notamment choisie telle qu'elle soit supérieure à la déformation du substrat 110 entre deux éléments de support 108 consécutifs ou à la déformation de part et d'autre d'un élément de support 108. Par exemple, un substrat 110 de forme carrée ayant des côtés égaux à 210 mm, une épaisseur de 130 µm et maintenu seulement par ses coins s'affaisse sous l'effet de son poids, notamment en son centre, d'environ 462 µm. Dans ce cas, la hauteur h des éléments de support 108 peut être choisie égale ou supérieure à 470 µm. Cette hauteur h peut aussi être légèrement inférieure à la déformation au centre du substrat 110 puisque l'affaissement au niveau des bords du substrat 110, où se trouvent les éléments 102, est inférieur à l'affaissement en son centre.

Bien entendu, la hauteur h des éléments de support 108 peut varier selon les dimensions (longueur, largeur, épaisseur) des substrats 110 à transporter et/ou selon l'espacement Es entre deux éléments de support 108 consécutifs. De manière générale, plus le format (longueur, largeur) des substrats 110 est petit, plus la déformation est faible. De plus, pour chaque format de substrats 110, la déformation augmente avec l'épaisseur. Autrement dit, plus l'épaisseur des substrats 110 est importante, plus la déformation est importante.

La configuration du système 100, dans laquelle les éléments 102 sont espacés l'un de l'autre, contribue également à éviter le risque de contact entre le substrat 110 et la face 102e externe des éléments 102 par déformation du substrat 110 entre des éléments de support 108 disposés chacun sur un élément 102 distinct.

La hauteur h des éléments de support 108 peut être aussi choisie telle qu'elle soit supérieure à la rugosité de régions du substrat 110 qui ne sont pas au contact des éléments de support 108.

La surface s des éléments de support 108 sur le substrat 110 est de préférence la plus petite possible afin de limiter au maximum l'aire de contact entre le substrat 110 et les éléments 102, tout en étant assez grande pour éviter la casse de ces éléments de support 108. L'aire d'une zone de contact d'un des éléments de support 108 avec le substrat 110 est par exemple comprise entre environ entre 0.5 mm² et 5mm², par exemple 1 mm².

Pour assurer la stabilité des éléments de support 108 et améliorer le maintien du substrat 110 tout en limitant la surface des éléments de support 108 sur le substrat 110, les éléments de support 108 ont une première section du côté de la face 102e externe de l'élément 102 qui présente des dimensions supérieures aux dimensions d'une deuxième section du côté du substrat 110. Ainsi, dans l'exemple de réalisation représenté sur la figure 6, l'élément de support 108 a une forme de cône tronqué. En variante, l'élément de support peut avoir une forme tétraédrique tronquée ou pyramidale tronquée, ou toute autre forme similaire.

Les figures 7 et 8 représentent l'élément de support 108 de la figure 6 pris de manière isolé. L'élément de support 108 comporte un trou 112 débouchant sur la surface s destinée à venir au contact du substrat 110. Cette surface s destinée est ainsi périphérique à l'extrémité du trou 112. Lorsque le substrat 110 est positionné sur le système 100, le trou 112 est obturé par le substrat 110 et créé une aspiration qui améliore le maintien du substrat 110 sur les éléments 102. Le trou 112 permet donc de réduire la surface s de l'élément de support 108 destinée à venir au contact du substrat 110 tout en améliorant le maintien du substrat 110 sur les éléments 102.

Le trou 112 présente globalement une section constante, sauf en partie supérieure de l'élément de support 108, à proximité de la zone de troncage, où la section du trou 112 est élargie afin de diminuer la surface s de contact avec le substrat 110, sans impacter la stabilité de l'élément de support 108. Plus généralement, l'élément de support 108 a une épaisseur e, c'est-à-dire la dimension entre une surface interne 108i définissant le trou 114 et une surface externe 108e, qui est de préférence amincie en partie supérieure de l'élément de support 108, à proximité de la zone de troncage.

### Nomenclature en référence aux dessins

100 : système de transport
102 : élément de manutention et/ou de maintien
102i : surface interne de l' élément de manutention et/ou de maintien
102e : surface externe de l' élément de manutention et/ou de maintien
104 : arbre rotatif
106 : moteur électrique
108 : élément de support
108i : surface interne de l'élément de support
108e : surface externe de l'élément de support
110 : substrat semi-conducteur
112 : trou
200 : ensemble
e : épaisseur de l'élément de support
Es : espacement entre deux éléments de support consécutifs
F : direction d'avancement de l'élément de manutention et/ou de maintien
h : hauteur de l'élément de support
L : dimension d'un bord ou d'un côté du substrat
Rc : région de contact
s : surface de l'élément de support destinée à venir au contact d'un substrat
Z : zone de la face externe de l'élément de manutention et/ou de maintien

## Revendications

1. Système de transport d'un substrat semi-conducteur (110), lors de la réalisation d'au moins un dispositif semi-conducteur comprenant ce substrat (110), ledit système comprenant au moins un élément de manutention et/ou de maintien (102) du substrat semi-conducteur (110), ledit au moins un élément de manutention et/ou de maintien (102) comprenant, sur au moins une zone (Z) d'une face (102e) dudit au moins un élément de manutention et/ou de maintien (102) destinée à être en regard d'une région de contact (Rc) du substrat (110), au moins un élément de support (108) en saillie par rapport à la face (102e) dudit au moins un élément de manutention et/ou de maintien (102), et destiné à venir au contact de la région de contact (Rc) du substrat (110) de sorte à maintenir à distance le substrat (110) et la face (102e) dudit au moins un élément de manutention et/ou de maintien (102), **caractérisé en ce que** l'au moins un élément de support (108) comprend un trou (112), notamment formé sur toute la hauteur (h) de l'au moins un élément de support (108), débouchant sur une surface (S) de l'au moins un élément de support (108) destinée à venir au contact du substrat (110).

2. Système de transport selon la revendication 1, dans lequel ledit au moins un élément de manutention et/ou de maintien (102) est solidaire d'un arbre rotatif (104) et entraîné en rotation par ledit arbre rotatif (104).

3. Système de transport selon l'une des revendications 1 ou 2, dans lequel ledit au moins un élément de manutention et/ou de maintien (102) comprend au moins une courroie.

4. Système de transport selon l'une quelconque des revendications 1 à 3, dans lequel l'au moins un élément de support (108) a une hauteur (h) minimale prédéfinie en fonction de dimensions, notamment l'épaisseur et le format, du substrat (110), la hauteur étant de préférence supérieure à 200 µm.

5. Système de transport selon l'une quelconque des revendications 1 à 4, dans lequel l'au moins un élément de support (108) a une surface (s) destinée à venir au contact du substrat (110) inférieure à 10 mm², de préférence comprise entre 0.5 mm² et 5 mm².

6. Système de transport selon l'une quelconque des revendications 1 à 5, dans lequel l'au moins un élément de support (108) a une forme conique, notamment tétraédrique, ou pyramidale, notamment une forme tronquée.

7. Système de transport selon l'une quelconque des revendications 1 à 6, dans lequel l'au moins un élément de support (108) a une épaisseur (e), entre une surface interne (108i) dudit au moins un élément de support (108) définissant le trou (112) et une surface externe (108e) dudit au moins un élément de support (108), qui est amincie du côté de la surface (S) destinée à venir au contact du substrat (110).

8. Système de transport selon l'une quelconque des revendications 1 à 7, dans lequel l'au moins un élément de manutention et/ou de maintien (102) comprend une pluralité d'éléments de support (108) alignés selon une direction de déplacement (F) de l'élément de manutention et/ou de maintien (102) et espacés régulièrement les uns des autres d'une distance (Es) prédéfinie en fonction de dimensions, notamment l'épaisseur et le format, du substrat (110), cette distance (Es) étant de préférence comprise entre 78 mm et 108,5 mm

9. Système de transport selon l'une quelconque des revendications 1 à 8, dans lequel ledit au moins un élément de support (108) est rapporté sur la face dudit au moins un élément de manutention et/ou de maintien (102), notamment par collage ou par soudage.

10. Ensemble de transport d'un substrat semi-conducteur (110), comprenant un système de transport (100) selon l'une quelconque des revendications 1 à 9 et un substrat semi-conducteur (110), dans lequel ledit au moins un élément de support (108) est au contact de la région de contact (Rc) dudit substrat (110) de sorte à maintenir à distance le substrat (110) et la face (102e) dudit au moins un élément de manutention et/ou de maintien (102) et dans lequel ledit trou (112) dudit au moins un élément de support (108) est obturé par ledit substrat (110).

11. Ensemble de transport selon la revendication 10, dans lequel l'au moins un élément de support (108) est au contact d'au moins un bord du substrat (110).

12. Ensemble de transport selon l'une des revendications 10 ou 11, dans lequel le substrat (110) a une forme rectangulaire, pseudo-rectangulaire, carrée ou pseudo-carrée et est au contact de quatre éléments de support (108), ces éléments de support (108) étant agencés sensiblement à chaque coin du substrat (110).

13. Ensemble de transport selon la revendication 10 à 12, dans lequel l'espacement (Es), suivant une direction d'avancement (F) de l'au moins un élément de manutention et/ou de maintien (102), entre deux éléments de support (108) consécutifs est sensiblement inférieur à la moitié de la dimension (L) d'un côté du substrat (110) le long duquel ces éléments de support (108) sont en contact.

14. Procédé de transport d'un substrat semi-conducteur (110) avec un ensemble de manutention et/ou de maintien (200) conforme à l'une quelconque des revendications 10 à 13, le procédé comprenant une étape de positionnement du substrat (110) au contact dudit au moins un élément de support (108) de sorte à maintenir à distance ledit substrat (110) et la face dudit au moins un élément de manutention et/ou de maintien (102) et à obturer ledit trou (112) dudit au moins un élément de support (108) avec ledit substrat (110).
